# EUROPEAN PATENT APPLICATION

(11) **EP 4 765 879 A1**
(43) Date of publication of application: **24.06.2026**
(21) Application number: 24222568.8
(22) Date of filing: 20.12.2024
(51) Int. Cl.: H04R 25/00, H04R 3/02, H05K 3/00

(54) **A HEARING DEVICE AND A METHOD OF MANUFACTURING A HEARING DEVICE**

(71) Applicant: GN Hearing A/S, 2750 Ballerup (DK)
(72) Inventor: TALWAR, Meenakshi, 2750 Ballerup (DK); PINTO, Alexandre Da Luz, 2750 Ballerup (DK); STEFFENS, Jens Henrik, 2750 Ballerup (DK)
(74) Representative: AWA Denmark A/S

(57) **Abstract**

Disclosed is a hearing device. The hearing device comprises a telecoil for communication in a first frequency band; a wireless communication device for communication in a second frequency band; and a printed circuit board, (PCB), comprising at least one conductive layer and at least one dielectric layer. The telecoil is arranged in a first section of the PCB and the wireless communication device is arranged in a second section of the PCB. The conductive layer comprises a first conductive trace provided in the first section of the PCB and a second conductive trace provided in the second section of the PCB. Further disclosed is a method of manufacturing a hearing device

## Description

### Field of the Invention

The present invention relates to a hearing device and a method of manufacturing a hearing device.

### Background

Hearing devices generally employ wireless radio communication for, *inter alia,* audio communication or control signals. Often, such hearing devices are configured to support more one than type of wireless communication, such as multiple protocols or communication over various frequency bands.

Typically, hearing aids comprise, as one type of wireless communication, a telecoil. A telecoil is generally understood as at least one, typically rather small, conductive wire, such as a copper wire, acting as a receiver to receive electromagnetic signals. Such telecoils operate unmodulated in the base-band and are well-employed and allow for receiving signals from venues, in which a corresponding sound system, also often referred to as a loop or loop system, converts these signals into audio. The audio is then typically provided to the user of the hearing device via a transducer of the hearing device.

As another type of wireless communication, hearing devices commonly employ a digital wireless radio communication technology operating in a different frequency range. Common digital wireless radio communications are, for instance, 2.4 GHz communication technologies, such as Bluetooth° technologies, or 5 GHz technologies.

Generally, hearing devices utilise printed circuit boards, PCBs, for mounting at least part of the electronics. Traces, i.e. conductive traces, on such a PCB are used for conducting electrical signals for various components. In such PCBs, the dimensioning of the PCB and, in particular, the length of the PCB can generally result in a frequency-dependent electric impedance, potentially causing frequency-dependent damping or resonances at certain frequencies. Such frequency-dependent electric impedances may cause a reduced wireless performance. It remains a desire to provide a hearing device with a PCB that allows for multiple types of wireless communication and provides an improved wireless performance.

It furthermore remains a general desire in the field of hearing devices to reduce the size of the hearing devices.

### Summary of the Invention

An object of the invention is to provide a hearing device overcoming at least some of the above-mentioned drawbacks.

This and further objects are achieved by a hearing device according to the present invention, the hearing device comprising:
a telecoil for communication in a first frequency band;
a wireless communication device for communication in a second frequency band;
a printed circuit board (PCB), comprising at least one conductive layer and at least one dielectric layer, wherein
the telecoil is arranged in a first section of the PCB and the wireless communication device is arranged in a second section of the PCB, wherein the conductive layer comprises a first conductive trace provided in the first section of the PCB and a second conductive trace provided in the second section of the PCB; wherein the PCB comprises:
a coupling element having a first end and a second end, and
a cut-out galvanically decoupling the first conductive trace from the second conductive trace, wherein the first end of the coupling element is connected to the first conductive trace and the second end of the coupling element is connected to the second conductive trace, wherein the coupling element is configured to provide a frequency-dependent coupling between the first conductive trace and the second conductive trace.

It has been realised that by providing the coupling element and the cut-out galvanically decoupling the first conductive trace and the second conductive trace, a decoupling may be achieved from a current perspective, in turn reducing noise for potential unmodulated wireless communication in the baseband, while allowing for an increased electrical length with a physically shorter PCB trace. This, in turn, allows for a PCB design, which provides an increased adaptability so that an improved wireless performance is achieved for both wireless technologies by allowing for an increased adaptability of electrical length and the alleviation of (DC) current loops, thereby reducing noise for unmodulated communication without increasing the physical dimensions of the PCB.

By providing the coupling element, an easy adaptation may furthermore be provided, in turn allowing for an improved flexibility of the PCB, as the decoupling element may be a component, which can be replaced to configure the frequency-dependent impedance provided by the traces for various frequency bands.

As an example, the telecoil may be configured to receive unmodulated signals in the first frequency band. Correspondingly, the telecoil may be perceptive to noise, which can reduce the performance, introduce audible artefacts into the signal provided to the user of the hearing device, or require additional signal processing to combat the noise, in turn requiring additional processing power, which it is generally desirable to minimise in battery-powered hearing devices. Given the size-constraints, certain traditional PCB designs introduce a trace extending around or forming a loop around the telecoil to provide a sufficient routing for, for instance, the communication signals from the wireless communication device, operating in the second frequency band. However, such a trace may cause a current loop to be created, in turn introducing noise into the wireless communication of the telecoil in the first frequency band. It has been realised with the present invention that by providing a decoupling element between the first and second end and a cut-out in the PCB, the current loop may be broken, in turn reducing the noise impeded on the communication in the first frequency band. By means of the decoupling element, a loop may be maintained in the second frequency band for the routing of the communication signals from the wireless communication device. Furthermore, the cut-out has been found to result in a different electrical length of the PCB when seen from the perspective of the wireless communication signals in the second frequency band, thereby allowing for moving a resonance frequency outside of, such as far outside of, the second frequency band.

In the present disclosure, the term electrical length, as will be well-known in the field, refers to a length of the PCB relative to a frequency of interest. Throughout the present disclosure, the electrical length is considered relative to the second frequency band and the term electrical length will, thus, be appreciated to relate to the second frequency band.

By a galvanic decoupling may herein be understood that the first and second traces are decoupled, at least across the gap, from a direct current perspective, at least during operation of the hearing device, in particular so that no direct current runs between the first and the second traces, at least across the gap, during operation of the hearing device.

By frequency-dependent coupling may herein be understood an electric connection with a frequency-dependent impedance. In particular, the frequency-dependent coupling may refer to a connection having a complex impedance with a non-zero imaginary part. In other words, an electric connection or coupling with an impedance varying with frequency may be provided by the frequency-dependent coupling.

Throughout the present disclosure, it will be appreciated that the term "telecoil", also commonly referred to as a T-coil, refers to a coil, e.g. a wound wire of conducting material, e.g., copper. The telecoil may be configured to receive magnetic, such as electromagnetic, signals. The telecoil may comprise a wire wound around a suitable core, for instance a ferrite rod. The telecoil may be configured to receive magnetic signals, such as unmodulated signals, from an inductive or induction loop. It will be appreciated that such telecoils are generally well-known and widely employed in, *inter alia,* hearing aids.

Throughout the present disclosure, it will be appreciated that the PCB generally refers to a layered structure comprising at least one conductive layer, i.e. a layer made from a conductive material, and at least one dielectric layer, i.e. a layer made from a dielectric material. In PCBs, several such layers are generally laminated together. Generally, the PCB may be configured for surface-mounting of electronic components and interconnection of such components by means of conductive traces formed in the conductive layer. Traces throughout the present disclosure, thus, generally refers to conductive pieces of material in a conducting layer. Such traces are typically provided by etching away parts of the conductive layers made from, e.g., copper, leaving behind the desired conductive traces.

The PCB may be a multi-layer PCB, such as a PCB including at least two layers of conductive material, such as copper, and at least one layer of dielectric material, such as a composite material, for instance FR-4, arranged in between the conductive layers. In some embodiments, the PCB is a four-layer PCB, i.e., comprising four layers of conductive material and three layers of dielectric material arranged in between each of the conductive layers and an adjacent layer of conductive material.

Where the PCB is a multi-layer PCB, the first and second traces may be provided in any conducting layer, such as in a top conductive layer or a bottom conductive layer of the PCB.

The cut-out may be a physical cut-out in the PCB, such as an opening provided in the PCB.

The decoupling element may be connected across the cut-out. A first conductive pad may be provided on a first side of the cut-out and connected to the first trace and a second conductive pad may be provided on the second side of the cut-out and connected to the second trace. The second side may be opposite the first side of the cut-out, for instance, so that the cut-out is arranged between and/or provides the galvanic decoupling between the first and second sides. The decoupling element may be connected with a first connecting portion thereof to the first pad and a second connecting portion thereof to the second pad, e.g. by soldering.

In some embodiments, the decoupling element is, or comprises, an electric component, such as a surface mount device, SMD, component. The decoupling element may be or comprise one or more passive components and/or one or more active components.

The hearing device may comprise a housing configured to house the PCB, the telecoil, the wireless communication device, and the coupling element. The housing may be configured to surround and/or enclose the PCB, the telecoil, the wireless communication device, and the coupling element. In some embodiments, the housing may be made from a polymer or plastic-based material.

The hearing device may alternatively or additionally comprise an acoustic transducer, such as an electro-acoustic transducer operatively connected to the PCB and configured to reproduce sound. The acoustic transducer may be configured to be inserted into an ear canal of a user, during use of the hearing device. The acoustic transducer may comprise, or be, an acoustic input transducer, such as a microphone, or an acoustic output transducer, such as a receiver, telephone, or loudspeaker.

The PCB may be flexible and/or bendable, e.g., so that the first section and the second section are hingedly bendable relative to each other and so that the PCB may bend while maintaining conductivity between the first and second section. Alternatively or additionally, the PCB may comprise a bend, optionally between the first and second sections.

The hearing device, such as the PCB thereof, may comprise at least one processing unit configured to receive and process signals received from the microphone, the telecoil, and the wireless communication device. The at least one processing unit may further be configured to provide signals to the wireless communication device to be transmitted. The at least one processing unit may be and/or comprise any one or more of a central processing unit, CPU, a micro-processing unit, MCU, a digital signal processor, DSP, a field-programmable gate array, FPGA, or the like. The at least one processing unit may be mounted on, and connected to, the PCB.

The hearing device, such as the PCB thereof, may alternatively or additionally comprise a memory, optionally coupled to the at least one processing unit. The memory may be configured to store instructions, which, when carried out by a processing unit, cause the at least one processing unit to receive and process signals received from the microphone, the telecoil, and the wireless communication device and/or to provide signals to the wireless communication device to be transmitted. The memory may be a non-volatile memory. The memory may be and/or comprise any one of a random-access memory, RAM, a read-only memory, ROM, or the like. The memory may be mounted on , and connected to, the PCB.

The hearing device, such as the PCB thereof, may comprise one or more acoustic transducers, such as microphones, for receiving audio signals. The one or more acoustic transducers may comprise at least one front microphone for, at least during use of the hearing device, facing towards the front, and/or at least one back microphone facing towards the back, optionally arranged distally of the of at least one front microphone relative to the face of the user.

Where the hearing device comprises one or more microphones, the at least one processing unit may be configured to receive and process signals received from the microphones. Alternatively or additionally, where the hearing device comprises at least one acoustic transducer, the at least one processing unit may be configured to process and provide signals to be reproduced and/or to be amplified to be reproduced by the acoustic transducer. The one or more microphones may be mounted on, and connected to, the PCB of the hearing device.

The wireless communication device may be and/or comprise a wireless communication module configured to provide wireless communication. The wireless communication device may comprise a transceiver configured to transmit and/or receive wireless communication signals. The wireless communication device may be configured to provide digital wireless communication, i.e., to receive and/or transmit digital wireless signals. The digital wireless signals may be modulated, wireless signals.

The wireless communication device may alternatively or additionally comprise any one or more of a processing unit, such as any one or more of a CPU, a MCU, a DSP, or the like, and a memory, such as any one or more of a RAM, ROM, or the like.

Where the hearing device comprises a processing unit and/or a memory, the wireless communication device may be integrated into the processing unit and/or memory of the hearing device.

The hearing device, such as the PCB of the hearing device, may further comprise an antenna configured to facilitate transmission and/or reception of wireless communication signals to and/or from the wireless communication device in the second frequency band. The antenna may be mounted on and/or connected to the PCB of the hearing device.

The hearing device may be configured to be battery-powered, i.e. configured to be powered by a battery, such as a rechargeable battery or a button-cell battery, e.g. a zinc-air battery. Where the hearing device comprises a housing, the housing may be configured to house the battery.

The hearing device, such as the PCB thereof, may comprise power terminals, configured to receive power from a power source, such as a direct current power source. Where the hearing device is configured to be battery-powered, the PCB may comprise battery terminals for connecting to the battery and receiving battery power signals, e.g., a plus terminal and a minus terminal, for powering the hearing device.

The PCB may further comprise a subsection of the first section of the PCB. The subsection of the first section may be adjacent to or extend from the telecoil, optionally to surround at least a portion of the periphery of the telecoil. The subsection may be a via-free subsection, e.g. a section in which no vias are provided. In the present disclosure, it will be appreciated that a via refers to any connection provided to connect a plurality of conductive layers of the PCB, i.e. in a transverse direction of the PCB. Alternatively or additionally, the subsection of the first section may be a transverse connection-free subsection, i.e. a subsection in which no conductive transverse connections are provided and/or a subsection in which no conductive connections are provided between conducting layers of the PCB.

The subsection may extend from one edge to another of the PCB, such as between two edges in a lateral direction of the PCB.

By providing a via- or transverse connection-free subsection, the introduced into the signals received by the telecoil may be further reduced.

The hearing device may alternatively or additionally comprise a magnetic induction coil, or MI, coil configured for short-range wireless communication in a frequency band different from the wireless communication module. The purpose of the MI coil is to communicate with a corresponding MI coil in another hearing device worn on the other side of a user's head. Further details of the MI coil is beyond the scope of this application.

In some embodiments, the telecoil is arranged in a recess in the first section of the PCB.

The telecoil may be arranged so that the first section of the PCB substantially surrounds the telecoil and/or a periphery or cross-section of a periphery of the telecoil, optionally except from the cut-out. The recess may be an opening connected to the cut-out. For instance, the recess may be a bore in the PCB, and the cut-out may extend from an exterior side of the PCB to the recess.

In some embodiments, the PCB has a lateral direction, a longitudinal direction, and a transverse direction, and wherein the cut-out of the PCB extends in the lateral direction.

The PCB may be longer in the longitudinal direction than in the lateral direction.

The at least one conductive layer and the at least one dielectric layer may be stacked and/or arranged on top of each other in the transverse direction. In particular, the at least one conductive layer may be in contact with the dielectric layer along the longitudinal and lateral direction of the PCB.

Alternatively or additionally, the conductive and dielectric layers of the PCB may be stacked or arranged alternatingly on top of each other in the transverse direction.

In some embodiments, the cut-out extends from the recess in the first section of the PCB to an edge of the first section of the PCB.

Thereby, there may be provided a galvanic decoupling on a side in the lateral direction of the telecoil, in turn preventing a direct current loop, as no galvanic connection is then provided on that side of the telecoil.

The edge may be an edge positioned laterally of the telecoil. Alternatively or additionally, the edge may extend in the longitudinal direction.

Alternatively, the cut-out may extend between the first and second sections, optionally so as to separate the two sections.

The coupling element may have a non-zero reactance. The coupling element may additionally have a non-zero resistance. Alternatively or additionally, the coupling element may have a substantially zero resistance, i.e. a resistance which stems from the non-ideal nature of components, such as equivalent series resistance (ESR), or the like.

The coupling element may be and/or may act as a filter, such as a high-pass filter or a band-pass filter, at least during operation of the hearing device.

In some embodiments, the coupling element is a capacitive coupling element, which capacitive coupling element is connected across the cut-out, wherein the capacitive coupling element is configured to provide a frequency-dependent coupling in the first section for frequencies in the second frequency band.

Thereby, the capacitive coupling element may provide a loop for alternating current signals, such as radio signals. Furthermore, an increased flexibility of the PCB may be achieved as the capacitive coupling element may be selected and/or be interchangeable, in turn allowing for the PCB to be used for communication at different frequencies by replacing the capacitive coupling element with a different capacitive coupling element, having a different capacitance.

By a capacitive coupling element may be understood a coupling element with a capacitive impedance and/or with a non-zero capacitance.

The capacitive coupling element may be configured to have a capacitance, which provides a low impedance and/or damping for frequencies in the second frequency band.

In some embodiments, a first end of the capacitive coupling element is connected to the first conductive trace and a second end of the capacitive coupling element is connected to the second conductive trace.

In some embodiments, the capacitive coupling element is a capacitor.

In some embodiments, the capacitive coupling element comprises a capacitor.

The capacitor may, for instance, be a ceramic capacitor or a film capacitor.

In some embodiments, the capacitive coupling element is or comprises a single capacitor. Alternatively, the capacitive coupling element may be or comprise a plurality of capacitors.

In some embodiments, the coupling element is an inductive coupling element, wherein the inductive coupling element is configured to provide a frequency-dependent coupling in the first section for frequencies in the second frequency band.

The inductive coupling element may provide identical advantages to the advantages described with respect to the capacitive coupling element.

Similarly, a inductive coupling element may be understood a coupling element with an inductive impedance and/or with a non-zero inductance.

The capacitive coupling element may be configured to have an inductance, which provides a low impedance and/or damping for frequencies in the second frequency band.

In some embodiments, the inductive coupling element is an inductor.

In some embodiments, the inductive coupling element comprises an inductor, such as an SMD inductor.

In some embodiments, the inductive coupling element is or comprises a single inductor. Alternatively, the inductive coupling element may be or comprise a plurality of inductors.

In some embodiments, at least a part of the first section of the PCB is adjacent to the telecoil.

In some embodiments, the first section extends along a periphery of the telecoil, such as along at least 10%, such as at least 20 %, such as at least 30 %, such as at least 40 %, such as at least 50% or more of a periphery of the telecoil when seen in a radial direction from the telecoil.

In some embodiments, the first trace extends along a periphery of the telecoil, such as along at least 10%, such as at least 20 %, such as at least 30 %, such as at least 40 %, such as at least 50% or more of a periphery of the telecoil when seen in a radial direction from the telecoil.

In some embodiments, the second frequency band is a radio frequency band.

The second frequency band may, correspondingly, be a frequency band used for transmission and reception of radio communication to and from the wireless communication device.

The second frequency band may, for instance, be a frequency band within the range from 20 kHz to 300 GHz, such as in the range from 300 MHz to 6 GHz. In some embodiments, the second frequency band may be an unlicensed frequency band, such as a frequency band at and/or including the frequency 900 MHz, 2.4 GHz, or 5.8 GHz, e.g., commonly referred to as a 900 MHz band, a 2.4 GHz band, or a 5.8 GHz band, respectively. Alternatively, the second frequency band may be a 5 GHz frequency band, such as a frequency band in the range from 5.250 GHz to 5.350 GHz.

In some embodiments, the second frequency band may be a frequency band between 2.0 GHz and 3.0 GHz. For instance, the second frequency band may be extending from 2.4 to 2.4835 GHz, such as from 2.402 to 2.48 GHz. Alternatively or additionally, the wireless communication device may be configured to communicate via a short-range wireless technology protocol. Alternatively or additionally, the wireless communication device may be configured to provide communication via Bluetooth^{®}, such as via a Bluetooth^{®} protocol, such as Bluetooth^{®} Low Energy (BLE), Bluetooth Classic (Bluetooth 1.0/2.0/2.0+EDR/2.1), and/or Bluetooth^{®} 5.0. Alternatively or additionally, the wireless communication device may be configured to provide communication via ZigBee, and/or Z-Wave.

In some embodiment, the wireless communication device may be configured to communicate via modulated radio signals.

In some embodiments, the first frequency band is a baseband.

By a baseband may herein be understood that the first frequency band is configured to receive unmodulated communication signals.

The first frequency band may alternatively or additionally be defined to largely correspond to the frequency range of the human hearing. Alternatively or additionally, the first frequency band may be in the range from 0 Hz to 20 kHz, such as from 20 Hz to 20 kHz.

In some embodiments, the hearing device is a hearing aid, such as a behind-the-ear (BTE) hearing aid.

By a behind-the-ear hearing aid may herein be understood a hearing aid configured to be worn outside of an outer ear of the user. The BTE hearing aid may be configured to be arranged, during use, on the outside of the outer ear, such as between an earlobe and a portion of the head of the user, such as a temporal region of the head of the user. The BTE hearing aid may be configured to be attached to the outer ear of the user.

The BTE hearing aid may comprise a tube to be inserted into the ear canal of the user and coupled to an acoustic transducer of the BTE hearing aid. The tube may be configured to route audio into the ear canal of the user.

In some embodiments, at least one acoustic transducer is arranged in the first section of the PCB.

The at least one acoustic transducer arranged in the first section may be a microphone. The at least one acoustic transducer may be or comprise an acoustic transducer as described in the preceding. For instance, the at least one acoustic transducer arranged in the first section may comprise a front microphone and a back microphone as described in the preceding.

An alternative first aspect of the present invention relates to a hearing device comprising
a telecoil for communication in a first frequency band;
a wireless communication device for communication in a second frequency band;
a printed circuit board, PCB, comprising at least one conducting layer and at least one dielectric layer, wherein the telecoil is arranged in a recess of a first section of the PCB and the wireless communication device is arranged in a second section of the PCB,
wherein each of the at least one conducting layer and at least one dielectric layer extends in a longitudinal and a lateral direction of the PCB, and wherein the at least one conducting layer and at least one dielectric layer are arranged adjacent to each other in a transverse direction of the PCB to provide a multi-layered PCB, and
wherein at least one conductive trace connected to the second section of the PCB is provided in the first section of the PCB, characterised in that the PCB comprises a cut-out in the PCB, the cut-out galvanically decoupling one or more of the at least one conductive traces from at least one conductive trace in the second section of the PCB, and a decoupling element configured to provide a frequency-dependent coupling of the one or more of the at least one conductive traces.

The hearing device of the alternative first aspect may have advantages similar to the hearing device of the first aspect of the invention. Any feature and/or embodiment described with respect to the first aspect may equally apply to the alternative first aspect.

In some embodiments, the cut-out is provided in the first section of the PCB.

In some embodiments, the cut-out extends from the recess of the first section in the PCB, to an exterior of the first section in the PCB, in the lateral direction.

In some embodiments, the first section of the PCB comprises a first lateral side portion and a second lateral side portion, the first lateral side portion extending between the recess and a first edge of the first section and the second lateral side portion extending between the recess and a second edge of the first section,
wherein the first section comprises a proximal section, connected to the second section, and a distal section opposite the proximal section in the longitudinal direction, and
wherein the one or more conductive traces for components arranged in the distal section, distally of the telecoil in the longitudinal direction, are provided in the first lateral side portion.

In some embodiments, a portion of the first section of the PCB, extending from one edge of the first section to an opposite edge of the first section, is free from vias. The at least part of the first section of the PCB may be adjacent to the telecoil.

In some embodiments, the cut-out is arranged to galvanically decouple the first section of the PCB from the second section of the PCB, and wherein the decoupling element further comprises at least one inductive decoupling component arranged to connect the one or more, such as each, of the at least one traces of the first section to the second section.

In some embodiments, the first section of the PCB is bendably connected to the second section.

In some embodiments, the first section is furthermore bendable around a portion thereof.

The second frequency band may be a radio frequency band.

A second aspect of the invention relates to a method of manufacturing a hearing device comprising the steps of:
providing a telecoil for communication in a first frequency band;
providing a wireless communication device for communication in a second frequency band;
providing a printed circuit board (PCB), comprising at least one conductive layer and at least one dielectric layer;
providing a first conductive trace in the conductive layer of a first section of the PCB;
providing a second conductive trace in the conductive layer of a second section of the PCB;
arranging the telecoil in the first section of the PCB;
arranging the wireless communication device in the second section of the PCB; wherein the method further comprises the steps of:
   providing a coupling element having a first end and a second end;
   providing a cut-out in the PCB galvanically decoupling the first conductive trace from the second conductive trace;
   connecting the first end of the coupling element to the first conductive trace;
   connecting the second end of the coupling element to the second conductive trace, wherein the coupling element is configured to a frequency-dependent coupling between the first conductive trace and the second conductive trace.

The method according to the second aspect may provide similar or identical advantages as described with respect to the hearing device according to the first aspect and/or with respect to the hearing device according to the alternative first aspect.

Correspondingly, any embodiment or feature described with respect to the hearing device according to the first aspect and/or with respect to the hearing device according to the alternative first aspect may equally apply to the method according to the second aspect of the present invention.

In some embodiments, the method according to the second aspect may be a method of manufacturing a hearing device according to the first aspect of the present invention.

It will be appreciated that the method steps may be provided in any order. In particular, it will be appreciated that the steps of providing the telecoil, providing the wireless communication device, providing the PCB, and providing the coupling element, may be provided in any order. The steps of providing the first conductive trace, providing the second conductive trace, and providing the cut-out in the PCB may be performed in any order subsequent to the step of providing the PCB. Furthermore, the steps of arranging the telecoil may be performed subsequent to the steps of providing the telecoil and the PCB, and the step of arranging the wireless communication device may be performed subsequent the steps of providing the wireless communication device and the PCB. Similarly the steps of connecting the first and second end of the coupling element may be performed subsequent to the steps of providing the coupling element, the PCB, and the first and second traces.

An alternative second aspect of the invention relates to a method of manufacturing a hearing device comprising the steps of:
providing a telecoil for communication in a first frequency band;
providing a wireless communication device for communication in a second frequency band;
providing a printed circuit board, PCB, comprising at least one conducting layer and at least one dielectric layer;
arranging the telecoil in a recess of a first section of the PCB and arranging the wireless communication device in a second section of the PCB,
wherein each of the at least one conducting layers and at least one dielectric layers extend in a longitudinal and a lateral direction of the PCB, and wherein the at least one conducting layers and at least one dielectric layers are arranged adjacent to each other in a transverse direction of the PCB to provide a multi-layered PCB, and
wherein at least one conductive trace connected to the second section of the PCB is provided in the first section of the PCB, characterised in that the PCB comprises a cut-out in the PCB, the cut-out galvanically decoupling one or more of the at least one conductive traces from at least one conductive trace in the second section of the PCB, and a decoupling element configured to provide a frequency-dependent coupling of the one or more of the at least one conductive traces.

The method according to the alternative second aspect may provide similar or identical advantages as described with respect to the hearing device according to the first aspect, with respect to the hearing device according to the alternative first aspect, and/or with respect to the method according to the second aspect.

Correspondingly, any embodiment or feature described with respect to the hearing device according to the first aspect, with respect to the hearing device according to the alternative first aspect, and/or with respect to the method according to the second aspect may equally apply to the method according to the second aspect of the present invention.

In some embodiments, the method according to the alternative second aspect may be a method of manufacturing a hearing device according to the alternative first aspect of the present invention.

The different aspects of the present invention can be implemented in different ways including a hearing device and a method of manufacturing a hearing device described above and in the following, each yielding one or more of the benefits and advantages described in connection with at least one of the aspects described above, and each having one or more preferred embodiments corresponding to the preferred embodiments described in connection with at least one of the aspects described above and/or disclosed in the dependent claims. Furthermore, it will be appreciated that embodiments described in connection with one of the aspects described herein may equally be applied to the other aspects.

A person skilled in the art will appreciate that any one or more of the above aspects of this disclosure and embodiments thereof may be combined with any one or more of the other aspects of the disclosure and embodiments.

### Brief Description of Drawings

In the following description, embodiments of the invention will be described with reference to the drawings, in which
Fig. 1 shows an embodiment of a hearing device according to the present invention during use;
Fig. 2 shows a cross-sectional view of part of the hearing device of the embodiment of the hearing device shown in Fig. 1;
Fig. 3 shows a perspective view of an embodiment of a prior art hearing device;
Fig. 4 shows a Smith chart of the prior art hearing device shown in Fig. 3;
Fig. 5 shows a Bode plot of the prior art hearing device shown in Fig. 3;
Fig. 6 shows a perspective view of the embodiment of the hearing device shown in Figs. 1 and 2;
Fig. 7 shows a Smith chart of the prior art hearing device shown in Fig. 6;
Fig. 8 shows a Bode plot of the prior art hearing device shown in Fig. 6;
Fig. 9 shows a perspective view of another embodiment of a hearing device according to the present invention;
Fig. 10 shows a Smith chart of the embodiment of the hearing device shown in Fig. 9;
Fig. 11 shows a Bode plot of the embodiment of the hearing device shown in Fig. 9;
Fig. 12 shows a flow chart of a method of manufacturing a hearing device according to the present invention.

Similar reference numerals are used for similar elements across the various embodiments and figures described herein.

### Detailed Description

The present invention will now be described in more detail hereinafter with reference to the accompanying drawings, in which embodiments of the invention are shown. The invention may, however, be embodied in many different forms within the scope of the claims set out herewith and should not be construed as limited to the embodiments set forth herein; rather, these embodiments are provided for thoroughness and completeness.

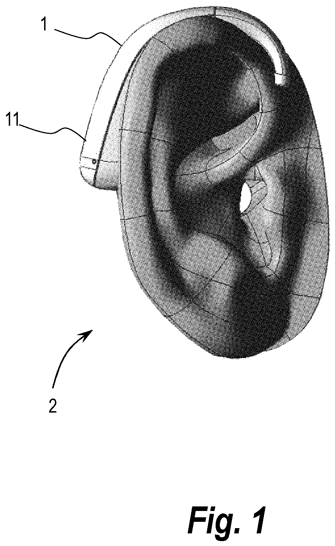

Figs. 1, 2 and 6 shows an embodiment of a hearing device 1 according to the present invention.

The hearing device 1 comprises a telecoil 7 for communication in a first frequency band and a wireless communication device for communication in a second frequency band. The wireless communication device is incorporated in a processor 21.

The hearing device 1 further comprises printed circuit board (PCB) 3, comprising at least one conductive layer and at least one dielectric layer.

The telecoil 7 is arranged in a first section 31 of the PCB and the wireless communication device, illustrated in the present embodiment as incorporated in the processor 21 is arranged in a second section 32 of the PCB. The conductive layer comprises a first conductive trace provided in the first section 31 of the PCB and a second conductive trace provided in the second section 32 of the PCB.

In other embodiments, the processor 21 may be or may comprise the wireless communication device. In yet other embodiments, the processor may be dispensed with and the wireless communication device may be a separate device.

The hearing device 1 further comprises a coupling element 4 having a first end and a second end.

Furthermore, the hearing device comprises a cut-out 17 galvanically decoupling the first conductive trace from the second conductive trace. The first end of the coupling element 4 is connected to the first conductive trace and the second end of the coupling element is connected to the second conductive trace. The coupling element 4 is configured to provide a frequency-dependent coupling between the first conductive trace and the second conductive trace.

In the embodiment shown in Fig. 1, the hearing device 1 is illustrated as a BTE hearing aid arranged outside an outer ear 2 of a user wearing the BTE hearing aid.

The hearing device comprises a housing 11 configured to house a PCB, the telecoil, the wireless communication device, and the coupling element. The housing 11 is configured to surround and/or enclose a PCB 3, a telecoil 7, a wireless communication device incorporated in a processor 21, and a coupling element 4.

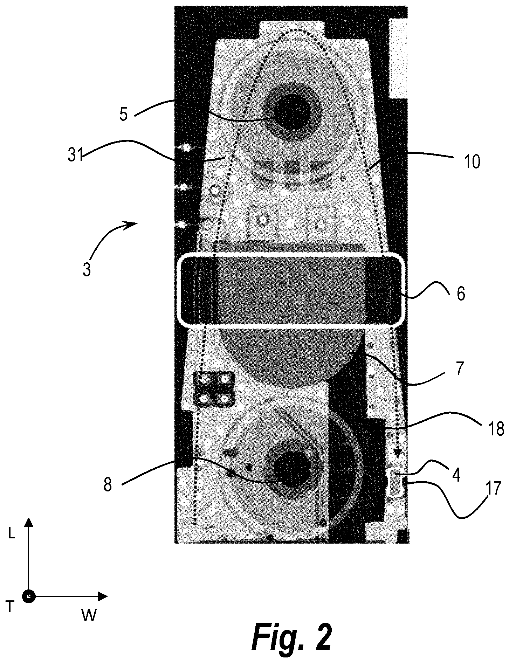

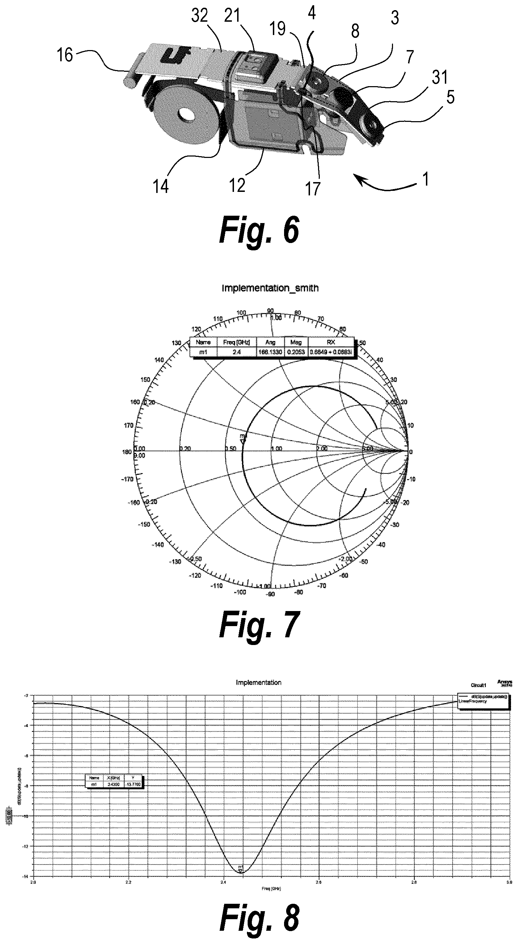

Fig. 2 shows a cross-sectional view of part of the embodiment of the hearing device 1 shown in Fig. 1, whereas Fig. 6 shows a perspective view of the hearing device 1 without housing 11.

In Fig. 2, a current loop 10 occurring in the PCB 3 by virtue of the first trace is shown, albeit interrupted by the cut-out 17 and coupling element 4, which provide for a galvanic decoupling.

The PCB 3 further comprises a subsection of the first section 31 of the PCB 3. The subsection of the first section 31 is adjacent to and extends from the telecoil 7 to surround at least a portion of the periphery of the telecoil 7. The subsection is a via-free subsection 6, i.e. a section in which no vias are provided, as shown in Fig. 2.

The hearing device 1 comprises acoustic transducers in the form of a front microphone 5 for, at least during use of the hearing device 1, facing towards the front, and a back microphone 8 facing towards the back and arranged distally of the one front microphone 5 relative to the face of the user.

The hearing device 1 is configured to be battery-powered, i.e. configured to be powered by a battery (not shown), such as a rechargeable battery or a button cell battery, e.g. a zinc-air battery. The hearing device housing 11 is configured to house the battery.

The hearing device 1 comprises battery terminals 14 for connecting to the battery and receiving battery power signals, e.g., a plus terminal and a minus terminal, for operating the hearing device 1.

The hearing device 1 furthermore comprises a magnetic induction, Ml, coil 16.

The hearing device 1 further comprises an antenna 14 configured to facilitate transmission and/or reception of wireless communication signals to and/or from the wireless communication device in the second frequency band. The antenna 14 is connected to the PCB 3 of the hearing device 1. The second frequency band is a 2.4 GHz frequency band extending from 2.0 GHz to 3.0 GHz as illustrated in the Smith chart shown in Fig. 7 and the Bode Plot in Fig. 8 showing the frequency response of the hearing device 1 in the frequency range from 2.0 to 3.0 GHz.

The telecoil is arranged in a recess 18 in the first section 31 of the PCB 3.

The PCB 3 has a lateral direction W, a longitudinal direction L, and a transverse direction T, and the cut-out of the PCB extends in the lateral direction W.

The telecoil 7 is arranged so that the first section 31 substantially surrounds a periphery of the telecoil, i.e., in a plane spanned in the longitudinal L and lateral direction W, except from the cut-out 17. The recess 18 is an opening connected to the cut-out 17.

The PCB 3 is longer in the longitudinal direction L than in the lateral direction W.

The PCB 3 is flexible and comprises a bend 19 between the first 31 and second 32 sections of the PCB 3.

The at least one conductive layer and the at least one dielectric layer are arranged on top of each other in the transverse direction T. The at least one conductive layer may be in contact with the dielectric layer along the longitudinal L and lateral direction W of the PCB.

The cut-out 17 extends from the recess 18 in the first section 31 of the PCB to an edge of the first section 31 of the PCB..

Thereby, there may be provided a galvanic decoupling on a side in the lateral direction of the telecoil, in turn preventing the direct current loop 10, as no galvanic connection is then provided on that side of the telecoil 7.

The edge is an edge positioned laterally W of the telecoil.

The coupling element 4 is a capacitive coupling element and comprises a capacitor, notably a single capacitor. In other embodiments, the coupling element 4 may comprise multiple capacitors and/or may be an inductive coupling element.

A part of the first section 31 of the PCB is adjacent to the telecoil 7.

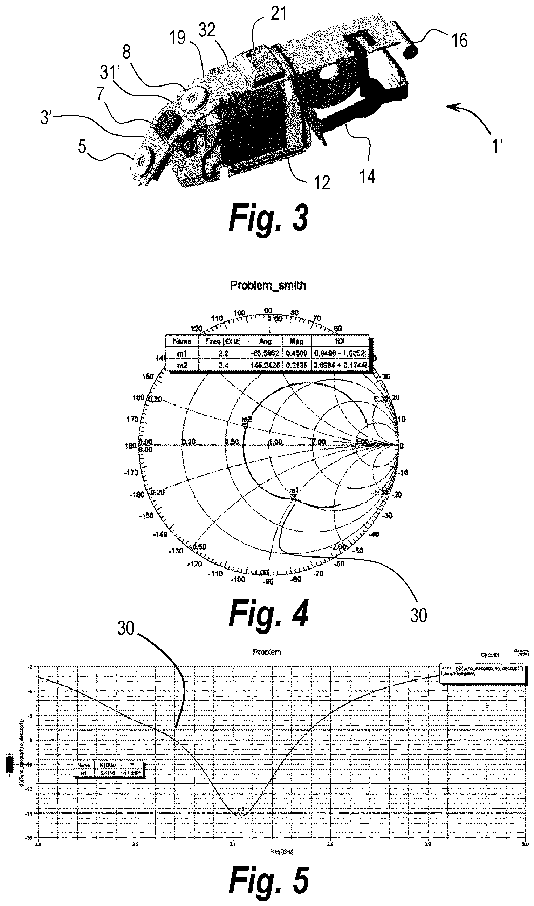

Fig. 3 shows a perspective view of an embodiment of a prior art hearing device 1'. As shown in Fig. 3, the prior art hearing device 1' equally comprises microphones 5, 8, processor 21 incorporating the wireless communication device as well as MI coil 16, antenna 12, and battery contact 14.

Prior art hearing device 1' further comprises a PCB 3' comprising a first section 31' and second section 32 and with bend 19. The PCB 3' is identical to the PCB 3 of the embodiment of the hearing device 1 shown in Figs. 1, 2, and 6, except that no cut-out is provided in the first section 31' of the PCB 3' or elsewhere in the PCB 3'.

Prior art hearing device 1' further differs from hearing device 1 according to the invention in that no coupling element is provided in prior art hearing device 1'.

Fig. 4 shows a Smith chart of the prior art hearing device 1' shown in Fig. 3 and Fig. 5 shows a Bode plot of the prior art hearing device 1' shown in Fig. 3. As seen in Figs. 4 and 5, an unwanted resonance 30 occurs at around 2.2 GHz in the prior art hearing device 1'.

It has been realised in the present invention that this can be alleviated by introducing the cut-out 17 and coupling element 4 of the hearing device 1 as shown in Figs. 1, 2, and 6, in turn resulting in the unwanted resonance 30 not occurring as may be seen in the Smith Chart and Bode plots shown in Figs. 7 and 8, respectively.

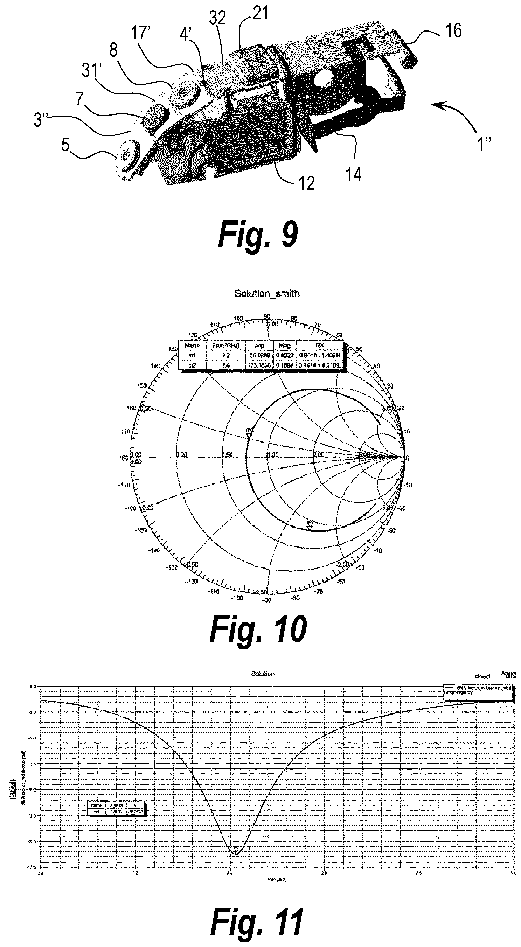

Fig. 9 shows a perspective view of another embodiment of a hearing device 1". Similar to hearing device 1 of the embodiment shown in Figs. 1, 2, and 6, and prior art hearing device 1', the hearing device 1" of the embodiment shown in Fig. 9 comprises microphones 5, 8, processor 21 incorporating the wireless communication device as well as MI coil 16, antenna 12, and battery contact 14.

The hearing device 1" further comprises a PCB 3", comprising a first section 31' and a second section 32, the second section being identical to the second sections 32 of the hearing devices 1 and 1'. The first section 31' is identical to the first section 31' of the prior art hearing device 1' shown in Fig. 3.

The hearing device 1" further comprises a cut-out 17'. The cut-out 17' is arranged in between the first 31' and second 32 sections of the PCB 3" and separates the first section 31' from the second section 32.

The hearing device 1" further comprises a coupling element 4'.

The coupling element 4' is an inductive coupling element in the form of a single inductor.

While illustrated without a housing, it will be appreciated that hearing devices 1' and 1" may equally comprise a housing similar or identical to housing 11.

As shown in Fig. 10, showing a Smith chart of the hearing device 1" and Fig. 11 showing a Bode plot of the hearing device 1", this equally provides a hearing device in which the unwanted resonance 30 as present in the prior art hearing device 1' is alleviated in the frequency band from 2.0 GHz to 3.0 GHz.

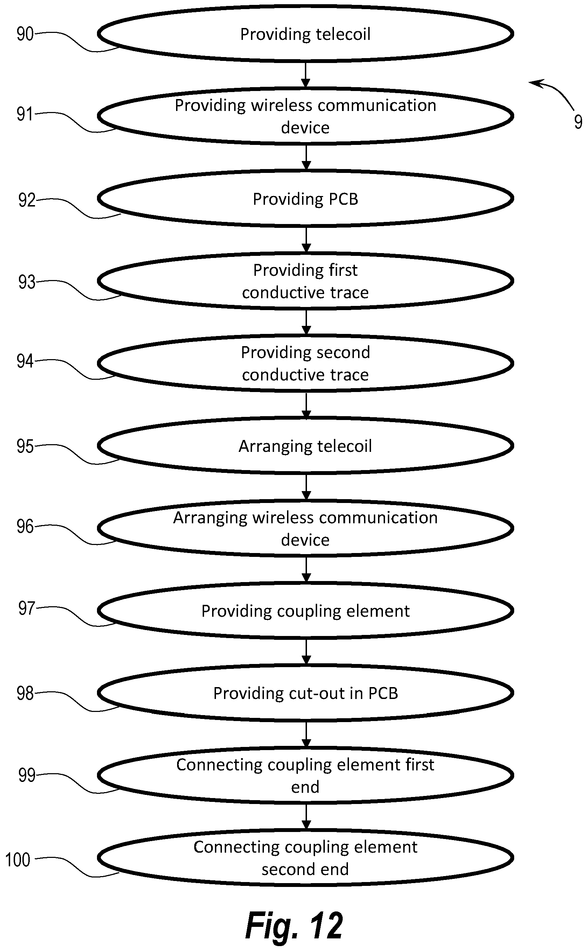

Fig. 12 shows a flow chart of a method 9 of manufacturing a hearing device according to the present invention.

The method 9 comprises the steps of:
providing 90 a telecoil for communication in a first frequency band;
providing 91 a wireless communication device for communication in a second frequency band;
providing 92 a printed circuit board (PCB), comprising at least one conductive layer and at least one dielectric layer;
providing 93 a first conductive trace in the conductive layer of a first section of the PCB;
providing 94 a second conductive trace in the conductive layer of a second section of the PCB;
arranging 95 the telecoil in the first section of the PCB;
arranging 96 the wireless communication device in the second section of the PCB;
providing 97 a coupling element having a first end and a second end;
providing 98 a cut-out in the PCB galvanically decoupling the first conductive trace from the second conductive trace;
connecting 99 the first end of the coupling element to the first conductive trace; and
connecting 100 the second end of the coupling element to the second conductive trace, wherein the coupling element is configured to a frequency-dependent coupling between the first conductive trace and the second conductive trace.

While illustrated as sequential, it will be appreciated that the steps 90-100 may be performed in any order. For instance, any of steps 90, 91, 92, and 97 may be performed simultaneously or in any sequential order. Alternatively or additionally, any of steps 93-96 and 98-100 may be performed subsequently to step 92 in any order or simultaneously.

The method 9 may be a method of manufacturing the hearing device 1 or 1".

Although some embodiments have been described and shown in detail, the invention is not restricted to these embodiments, but may also be embodied in other ways within the scope of the subject matter defined in the following claims. In particular, it is to be understood that other embodiments may be utilised, and structural and functional modifications may be made without departing from the scope of the present invention.

In device claims enumerating several means, several of these means can be embodied by one and the same item of hardware. The mere fact that certain measures are recited in mutually different dependent claims or described in different embodiments does not indicate that a combination of these measures cannot be used to advantage.

It should be emphasized that the term "comprises/comprising" when used in this specification is taken to specify the presence of stated features, integers, steps or components but does not preclude the presence or addition of one or more other features, integers, steps, components or groups thereof.

### List of reference numerals

- 1: Hearing device
- 1': Prior art hearing device
- 1": Hearing device
- 2: Outer ear
- 3: PCB
- 3': PCB
- 3": PCB
- 4: Coupling element
- 4': Coupling element
- 5: Front microphone
- 6: No-via subsection
- 7: Telecoil
- 8: Rear microphone
- 10: Direct current loop
- 11: Housing
- 12: Antenna
- 14: Battery contact
- 16: Magnetic Induction (Ml) coil
- 17: PCB cut-out
- 17': PCB cut-out
- 18: Recess
- 19: PCB bend
- 21: Processor
- 30: Unwanted Resonance
- 31: First section
- 31': First section
- 32: Second section
- 9: Method
- 90: Method step
- 91: Method step
- 92: Method step
- 93: Method step
- 94: Method step
- 95: Method step
- 96: Method step
- 97: Method step
- 98: Method step
- 99: Method step
- 100: Method step
- L: Longitudinal direction
- T: Transverse direction
- W: Lateral direction

### I T E M S

1. A hearing device comprising
   a telecoil for communication in a first frequency band;
   a wireless communication device for communication in a second frequency band;
   a printed circuit board, PCB, comprising at least one conducting layer and at least one dielectric layer, wherein the telecoil is arranged in a recess of a first section of the PCB and the wireless communication device is arranged in a second section of the PCB,
   wherein each of the at least one conducting layer and at least one dielectric layer extends in a longitudinal and a lateral direction of the PCB, and wherein the at least one conducting layer and at least one dielectric layer are arranged adjacent to each other in a transverse direction of the PCB to provide a multi-layered PCB, and
   wherein at least one conductive trace connected to the second section of the PCB is provided in the first section of the PCB, characterised in that the PCB comprises a cut-out in the PCB, the cut-out galvanically decoupling one or more of the at least one conductive traces from at least one conductive trace in the second section of the PCB, and a decoupling element configured to provide a frequency-dependent coupling of the one or more of the at least one conductive traces.
2. The hearing device according to item 1, wherein the cut-out is provided in the first section of the PCB.
3. The hearing device according to item 2, wherein the cut-out extends from the recess of the first section in the PCB, to an exterior of the first section in the PCB, in the lateral direction.
4. The hearing device according to any one of items 2 or 3, wherein the decoupling element is a capacitive decoupling element, which capacitive decoupling element is connected across the cut-out so that a frequency-dependent coupling is provided in the first section for frequencies in the second frequency band.
5. The hearing device according to item 4, wherein the capacitive decoupling element is a capacitor.
6. The hearing device according to any one of the preceding items, wherein the first section of the PCB comprises a first lateral side portion and a second lateral side portion, the first lateral side portion extending between the recess and a first edge of the first section and the second lateral side portion extending between the recess and a second edge of the first section,
   wherein the first section comprises a proximal section, connected to the second section, and a distal section opposite the proximal section in the longitudinal direction, and
   wherein the one or more conductive traces for components arranged in the distal section, distally of the telecoil in the longitudinal direction, are provided in the first lateral side portion.
7. The hearing device according to any one of the preceding items, wherein a portion of the first section of the PCB, extending from one edge of the first section to an opposite edge of the first section, is free from vias.
8. The hearing device according to item 7, wherein the at least part of the first section of the PCB is adjacent to the telecoil.
9. The hearing device according to any one of the preceding items, wherein the cut-out is arranged to galvanically decouple the first section of the PCB from the second section of the PCB, and wherein the decoupling element further comprises at least one inductive decoupling component arranged to connect the one or more, such as each, of the at least one traces of the first section to the second section.
10. The hearing device according to any one of the preceding items, wherein the first section of the PCB is bendably connected to the second section.
11. The hearing device according to any one of the preceding items, wherein the first section furthermore is bendable around a portion thereof.
12. The hearing device according to any one of the preceding items, wherein the second frequency band is a radio frequency band.
13. The hearing device according to any one of the preceding items, wherein the hearing device is a hearing aid, such as a behind-the-ear, BTE, hearing aid.
14. The hearing device according to any one of the preceding items, wherein at least one transducer is furthermore arranged in the first section of the PCB.
15. A method of manufacturing a hearing device comprising the steps of:
   providing a telecoil for communication in a first frequency band;
   providing a wireless communication device for communication in a second frequency band;
   providing a printed circuit board, PCB, comprising at least one conducting layer and at least one dielectric layer;
   arranging the telecoil in a recess of a first section of the PCB and arranging the wireless communication device in a second section of the PCB,
   wherein each of the at least one conducting layers and at least one dielectric layers extend in a longitudinal and a lateral direction of the PCB, and wherein the at least one conducting layers and at least one dielectric layers are arranged adjacent to each other in a transverse direction of the PCB to provide a multi-layered PCB, and
   wherein at least one conductive trace connected to the second section of the PCB is provided in the first section of the PCB, characterised in that the PCB comprises a cut-out in the PCB, the cut-out galvanically decoupling one or more of the at least one conductive traces from at least one conductive trace in the second section of the PCB, and a decoupling element configured to provide a frequency-dependent coupling of the one or more of the at least one conductive traces.

## Claims

1. A hearing device comprising:
a telecoil for communication in a first frequency band;
a wireless communication device for communication in a second frequency band;
a printed circuit board, PCB, comprising at least one conductive layer and at least one dielectric layer, wherein
the telecoil is arranged in a first section of the PCB and the wireless communication device is arranged in a second section of the PCB, wherein the conductive layer comprises a first conductive trace provided in the first section of the PCB and a second conductive trace provided in the second section of the PCB; **characterised in that** the PCB comprises:
a coupling element having a first end and a second end, and
a cut-out galvanically decoupling the first conductive trace from the second conductive trace, wherein the first end of the coupling element is connected to the first conductive trace and the second end of the coupling element is connected to the second conductive trace, wherein the coupling element is configured to provide a frequency-dependent coupling between the first conductive trace and the second conductive trace.

2. The hearing device according to claim 1, wherein the telecoil is arranged in a recess in the first section of the PCB.

3. The hearing device according to claim 1 or claim 2, wherein the PCB has a lateral direction, a longitudinal direction, and a transverse direction, and wherein the cut-out of the PCB extends in the lateral direction.

4. The hearing device according to claim 3, wherein the cut-out extends from the recess in the first section of the PCB to an edge of the first section of the PCB.

5. The hearing device according to claim 1-4, wherein the coupling element is a capacitive coupling element, which capacitive coupling element is connected across the cut-out, wherein the capacitive coupling element is configured to provide a frequency-dependent coupling in the first section for frequencies in the second frequency band.

6. The hearing device according to claim 5, wherein a first end of the capacitive coupling element is connected to the first conductive trace and a second end of the capacitive coupling element is connected to the second conductive trace.

7. The hearing device according to claim 5 or 6, wherein the capacitive coupling element is a capacitor.

8. The hearing device according to claim 1-4, wherein the coupling element is an inductive coupling element, wherein the inductive coupling element is configured to provide a frequency-dependent coupling in the first section for frequencies in the second frequency band.

9. The hearing device according to any one of the preceding claims, wherein at least a part of the first section of the PCB is adjacent to the telecoil.

10. The hearing device according to any one of the preceding claims, wherein the second frequency band is a radio frequency band.

11. The hearing device according to any one of the preceding claims, wherein the first frequency band is a baseband.

12. The hearing device according to any one of the preceding claims, wherein the hearing device is a hearing aid, such as a behind-the-ear, BTE, hearing aid.

13. The hearing device according to any one of the preceding claims, wherein at least one acoustic transducer is arranged in the first section of the PCB.

14. The hearing device according to any one of the preceding claims, wherein the PCB is a multi-layer PCB.

15. A method of manufacturing a hearing device comprising the steps of:
providing a telecoil for communication in a first frequency band;
providing a wireless communication device for communication in a second frequency band;
providing a printed circuit board, PCB, comprising at least one conductive layer and at least one dielectric layer;
providing a first conductive trace in the conductive layer of a first section of the PCB;
providing a second conductive trace in the conductive layer of a second section of the PCB;
arranging the telecoil in the first section of the PCB;
arranging the wireless communication device in the second section of the PCB; **characterised in** the steps of:
providing a coupling element having a first end and a second end;
providing a cut-out in the PCB galvanically decoupling the first conductive trace from the second conductive trace;
connecting the first end of the coupling element to the first conductive trace;
connecting the second end of the coupling element to the second conductive trace, wherein the coupling element is configured to a frequency-dependent coupling between the first conductive trace and the second conductive trace.
